# EUROPEAN PATENT APPLICATION

(11) **EP 4 184 250 A1**
(43) Date of publication of application: **24.05.2023**
(21) Application number: 21209747.1
(22) Date of filing: 23.11.2021
(51) Int. Cl.: G03F 7/20

(54) **OBTAINING A PARAMETER CHARACTERIZING A FABRICATION PROCESS**

(71) Applicant: ASML Netherlands B.V., 5500 AH Veldhoven (NL)
(72) Inventor: HELFENSTEIN, Patrick Philipp, 5500 AH Veldhoven (NL); SCHOLZ, Sandy Claudia, 5500AH Veldhoven (NL); VAN RIJSWIJK, Loes Frederique, 5500 AH Veldhoven (NL); MIDDLEBROOKS, Scott Anderson, 5500 AH Veldhoven (NL)
(74) Representative: ASML Netherlands B.V.

(57) **Abstract**

A measurement process is performed for each of a plurality of locations on a product of a fabrication process at which a parameter of interest characterizing the fabrication process is believed to be the same, to derive measured signals for each location including at least one image. A dimensional reduction method is applied to a dataset of the measured signals, to obtain components of the dataset, including components indicative of variation between the images. For at least one of these components, one or more associated ones of the measured signals are identified, comprising at least one set of corresponding pixels in the respective images for the plurality of locations. The contribution of the identified measured signals in the dataset is reduced or eliminated to obtain a filtered signal, and the parameter of interest is obtained from the filtered signal.

## Description

### FIELD

The present invention relates to a method for estimating a parameter characterizing a fabrication process, such as a lithographic process or other etching process.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

### SUMMARY

The present invention relates to obtaining a parameter characterizing a fabrication process by observing products of the fabrication process. The fabrication process may be a lithographic process as described above, but more generally may be any fabrication process, such as any etching process. The parameter of the fabrication process which is of interest may be a parameter indicative of a fault in the fabrication process. The products of the fabrication process are observed by collecting measured signals from a plurality of locations on one or more the products, e.g. a predefined array of locations on the respective surface of each of the one or more products, such as using the metrology techniques described above to obtain imaging data. The measured signals may be corresponding measured signals for each of the locations on the product(s).

When doing parameter estimation from imaging data, a large amount of information from thousands to millions of pixels has to be processed. The parameter of interest is overlaid or convolved with unwanted parasitic information due to noise and changing experimental conditions. Another possible source of parasitic information is changes in layer thickness or other variations in the fabrication process not connected to the parameter of interest.

In general terms, the invention proposes identifying which of the measured signals (in particular, pixels of images of the product) are associated with the parasitic information, and removing these measured signals from the measured signal dataset, or at least reducing their importance relative to other measured signals, to form a filtered signal. The parameter of interest is easier to extract from the filtered signal, and using the filtered signal in place of the raw data increases the accuracy of estimating the parameter of interest. In some cases, the data from which the parameter of interest is estimated is confined to small clusters spread across the image.

The measured signals which are associated with the parasitic information may be identified by supposing that the total dataset of measured signals can be split into multiple sets of measured signals for which the parameter of interest is unchanging. For example, the parameter of interest may be substantially the same at each of the plurality of locations on the product (e.g., this may be true for a plurality of locations on a die produced in lithographic process), so that, considering the measured signals which are derived from any one location (e.g. one or more images of that location) as a set of measured signals, variations in corresponding measured signals derived from different ones of a given location is due to factors other than variations in the parameter of interest. Similarly, the parameter of interest may be substantially the same for sets of measured signals derived from corresponding locations on multiple products of the fabrication process produced sequentially (i.e. by the same lithographic apparatus) within a certain time window (a time window within which it is believed that the parameter of interest does not significantly change). A set of measured signals may be considered as defining a point in a "measurement space", which has respective dimensions for each measured signal in the set of measured signals.

The measured signals which are associated with the parasitic information may be identified by applying, to a dataset including the measured components, a method for extracting at least one component indicative of variations in the measured signals between the locations, e.g. components indicative of statistical variations in the measured signal between those locations (e.g. with a statistical significance above a certain threshold). An example of method for extracting at least one component indicative of variations in the measured signals between the locations is a dimensional reduction technique. The dimensional reduction technique obtains multiple components, at least some of which characterize the variation between the sets of measured signals.

Generally speaking, the dimensional reduction technique reduces the dimensionality of the dataset, thereby describing the dataset using fewer dimensions or components than are present in the original dataset itself. If the dataset contains a plurality of sets of corresponding measured signals (e.g. one or more images of a given location), the dimensional reduction technique may obtain a number of components less than the number of elements of each set. For example, the number of components derived by the dimensional reduction technique may be less than the number of measured signals in the dataset obtained by measuring of a single location on the product at a single time.

The obtained components may include one or more components indicating corresponding features which are common between the sets of measured signals. The obtained components may also include one or more other components which are indicative of sources of variance in the measured signals, such as independent sources of variance. For example, if the measured signals are derived from different locations on the product, the components may include components associated with sources of variance in corresponding ones of the measured signals relating to different ones of the locations and/or in corresponding ones of the measured signals relating to the same location on a single product measured at different times and/or in corresponding ones of the measured signals relating to corresponding locations on different products produced within the time window.

One or more of the components of the dimension reduction technique may be selected, such as the one or more largest components (i.e. the largest component or few largest components) associated with variance between different sets of the measured signals. The magnitude of a component in this respect may be defined by the ratio of information present in the original signal (e. g. variance) it contains. For each of these one or more selected components, corresponding ones of the measured signals are identified - that is, there is an inverse transform from the dimensionally-reduced space in which the components are defined into the measurement space - to identify measured signals associated with the identified components.

The identified measured signals are thus statistically associated with the parasitic noise. These measured signals are either eliminated from the dataset of measured signals or else are reduced in amplitude, to produce a filtered signal. Thus, the filtered signal represents a version of the dataset of measured signals in which measured signals which are most seriously affected by parasitic noise have been suppressed or eliminated. In other words, the filtered signal is more informative about the parameters of interest than the original dataset of measured signals. This is particularly true if the selected one or more components are the one(s) which makes the largest contribution to the variance between the sets of measured signals.

As mentioned above, the measured signals typically comprise at least one respective pixelated image obtained for each of the locations. For example, for each location, there may be at least one set of measured signals which is a diffraction image obtained by measuring that location at a given time; alternatively or additionally, for each location there may be at least one set of measured signals which is a respective real-space image for that location. In either case, the measured signals identified as being associated with the selected components may be one or more pixels of the image. In particular, they may be one or more corresponding pixels in respective images for the plurality of locations in one or more products. Removing, or reducing the intensity of these pixels is equivalent to defining a mask which is applied to each of the images, so as to mask out (partially or entirely) the pixels which were found to be associated with the identified components. It has been found experimentally that screening out pixels of diffraction images which are associated with selected components obtained from the dimensional reduction technique results in a set of remaining pixels with a very much lower level of parasitic noise.

Once the identified measured signals are reduced or removed from the measured signal dataset, the remaining measured signals in the dataset may be used to estimate the parameter of interest of the fabrication process according to a known method.

In some examples, the parameter of interest may be obtained directly from the filtered signal. For example, the parameter of interest may be a focus value and/or a dose value for each of the locations.

Alternatively or additionally, the filtered signal may be used to determine whether the parameter of interest changes while a certain time has passed, i.e. whether the parameter of interest is different as between a first time (which is the time at which the products of the fabrication process were produced which were used to obtain the filtered signal), and at least one second time. One or more additional products of the fabrication process, produced by the fabrication process at the (or each) second time, may be obtained. These additional products are measured to produce additional measured signals. The additional measured signals, derived from the products produced at the second time, are compared with the filtered signal to identify a change in the parameter of interest between the first and second times. For example, the comparison may compare measured signals derived from the additional products with corresponding measured signals retained in the filtered signal. Optionally, the process described above may be performed for the additional measured signals, to obtain a corresponding additional filtered signal corresponding to the (or each) second time, and the comparison may be performed between the filtered signal (corresponding to the first time) and the additional filtered signal(s) (corresponding to the second time(s)).

One way of performing the dimensional reduction uses a known linear method called Principal Component Analysis (PCA) which transforms the dataset of measured signals according to the explained variance of the resulting components in a lower dimensional target space. A PCA is conventionally defined as a statistical procedure that uses an orthogonal transformation to convert a set of observations of possibly correlated variables (which in this case may be corresponding measured signals from different locations, and/or from the same locations at different times) into a set of values of linearly uncorrelated variables called principal components. However, there are other methods which can achieve the dimensional reduction. PCA is directly related to singular value decomposition (SVD) with the only difference that PCA works with centered data. Centering in this context means scaling by subtracting the mean of each feature of the data (followed by an optional division with the standard deviation).

Another known statistical technique is independent component analysis, which identifies maximally independent components in the dataset of measured signals taking into account higher order correlations in the data, e.g. correlations of at least second order. While PCA is used to achieve a dimensionality reduction of a signal, ICA produces independent sub-signals.

For all these dimensional reduction methods, there may be a step of selecting one or more of the components obtained by the dimensional reduction method to use in the later steps of the method (that is, selecting which of the components should be used to identify measured signals to remove/reduce to form the filtered signal). For example, a predefined number of the largest components associated with variance between the sets of measured signals may be identified in the case of PCA (or SVD) where there is an intrinsic weighing of the components present. Alternatively, a certain number of the components (e.g. the largest components associated with variance) may be identified, such that together the identified components meet a certain criterion, e.g. that together they explain a certain proportion of the variation between the sets of measured signals.

Another suitable dimensional reduction technique uses a machine learning model with a latent space defined by a plurality of latent variables. The data space of the input and/or output of the machine learning model may be the measurement space. The latent space may have a lower dimensionality than the measurement space. The identified components may be respective latent variables of the latent space. All of the latent variables may be used as the components from which measured signals are identified, or a selected sub-set of them (e.g. just the those latent variables associated with parasitic noise when a certain set of measurement values is input to the machine learning model).

For each such latent variable, the transformation from the given latent variable in the latent space to one or more signals in the measurement space may be performed in a way dependent on the machine learning model. For example, for some machine learning models (e.g. auto-encoders) both an input and an output of the machine learning model are points in the measurement space, where the output of the machine learning model is produced by a process which inverts the steps which transform an input to the machine learning model into the latent variables. For such machine learning models, the transform can be performed by inputting at least one set of the measured signals into the machine learning model to obtain values for each of the latent variables; modifying the value of the latent variable which it is desired to transform into the measurement space, such that the machine learning model outputs an "inverted signal" in the measurement space; and identifying the measured signals as one or more of the measured signals for which the input set of the measured signals differs by the greatest extent from the corresponding elements of the inverted signal.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 is a flow diagram of steps in a method which is an embodiment of the invention
- Figure 7 illustrates a plurality of products of a lithographic fabrication process, and illustrates samples to which the method of Figure 6 is applied;
- Figure 8 is composed of Figure 8(a) which is a pixelated diffraction image for one location on a die in one of the samples of Fig. 7, and Figure 8(b) which is an enlargement of a portion of the diffraction images of Figure 8(a);
- Figure 9 illustrates, for the samples of Figure 7, a variation of the amplitude of a principal component of diffraction images obtained from locations on the samples;
- Figure 10 shows the result of a regression to focus based on the diffraction images, using a 3-layer neural network having 50, 20 and 10 neurons per layer;
- Figure 11 illustrates how, in the embodiment, certain pixels of the diffraction image of Figure 8(b) are masked;
- Figure 12 illustrates how, upon performing the masking the diffraction images for all locations of all dies of all the samples, the variation of the amplitude of the principal component across each die of the samples is reduced;
- Figure 13 shows the results of a regression to focus based on the masked diffraction images; and
- Figure 14 shows a variational auto-encoder employed in a further embodiment of the invention.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

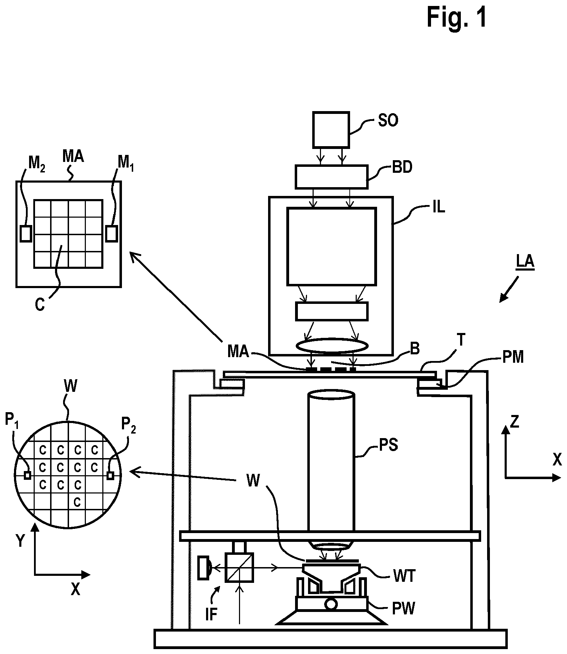

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

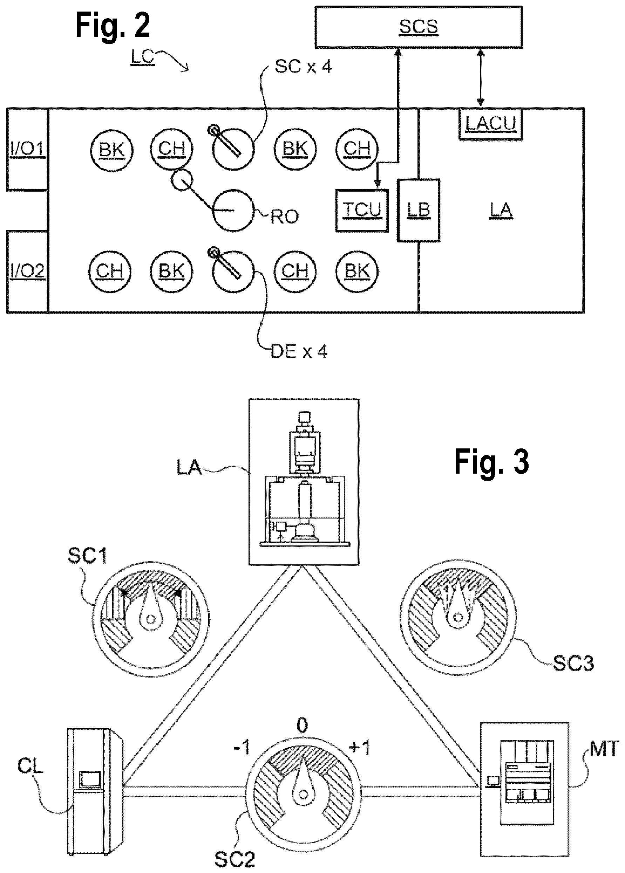

As shown in Figure 2 the lithographic apparatus LA may form part of a lithographic cell LC, also sometimes referred to as a lithocell or (litho)cluster, which often also includes apparatus to perform pre-and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

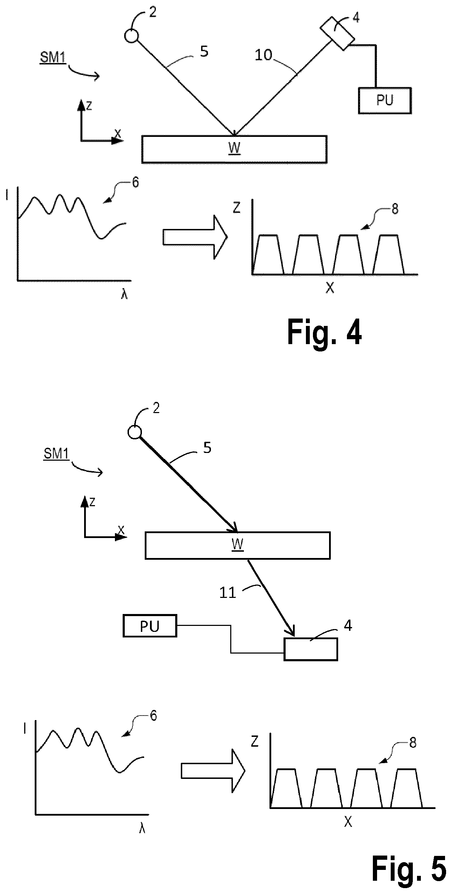

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

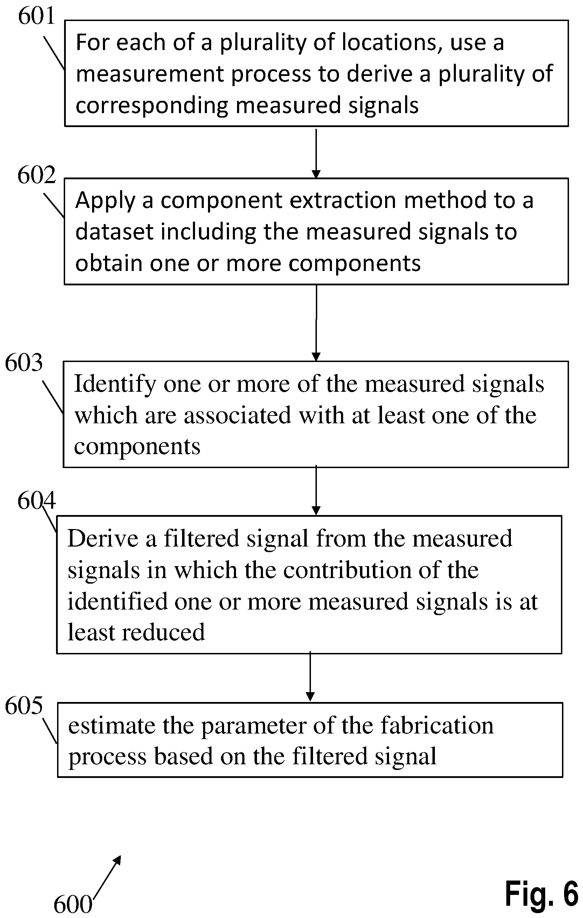

Referring now to Figure 6, a method 600 which is an embodiment of the invention will be described. In a first step 601 of the method 600, for each of a plurality of locations on one or more products of the fabrication process, a measurement process is carried out, at at least one time, to derive a dataset including a plurality of corresponding measured signals derived from the locations. The measured signals for each of the locations include one or more pixel values for each of the pixels of at least one corresponding image of the location.

More generally, for each of the locations there is at least one set of measured signals, and there is a correspondence between elements of different ones of the sets of measured signals. For example, if there are multiple sets of measured signals for a given location (e.g. multiple images of the location taken at different times of with different imaging modalities), there may be a one-to-one mapping between elements of a first of the sets of measured signals and elements of another of the sets of measured signals. Similarly, there may be a one-to-one mapping between elements of a set of measured signals for one of the locations (e.g. an image of the location) and elements of respective sets of measured signals for the other locations (e.g. respective images of the other locations).

In step 602, a component extraction method is applied to the dataset of the measured signals, to determine a number of components indicative of variations in the measured signals between the locations. The number of components may be less than the number of measured signals for each of the locations in which case the component extraction method is a dimensional reduction method.

In step 603, one or more of the measured signals which are associated with at least one of the components are identified.

In step 604, the identified measured signals are removed from the dataset of measured signals, to derive a filtered signal.

In step 605, the filtered signal is used to estimate a parameter of interest of the fabrication signal.

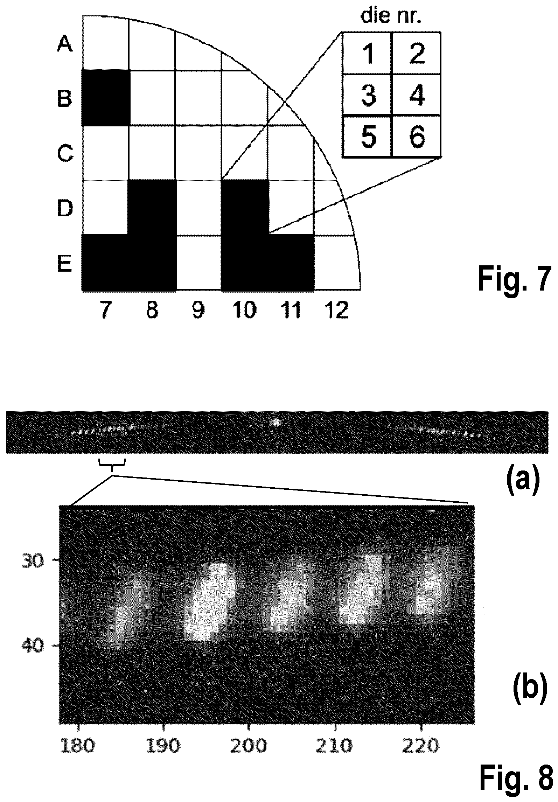

An example implementation of the method 600 will now be explained by reference to Figures 7-12. The steps of the method 600 are applied successively to a plurality of products produced at the same time by a lithography process. Specifically, as illustrated in Figure 7, the lithographic process produces a two-dimensional array of gratings, which are each considered respective products of the lithographic process (such as a quasi-periodic diffraction grating). The array of gratings has a shape which corresponds generally to a quarter of a circle. The gratings produced in the fabrication process may include further gratings (not shown) which complete the circle.

The array of gratings shown in Figure 7 is notionally partitioned into rectangular areas and two transverse axis are defined labelled respectively by letters A-E and numerals 7 to 12. Each of the rectangular areas, as shown by the top right portion of Figure 7, includes six dies. Each of the dies is a one-dimensional grating with a 90nm pitch. Seven of the rectangular areas were investigated, as described below, and each such rectangular area is referred to as a "sample". The seven samples are shown shaded in Figure 7. Because the positions of the samples in the array of gratings are different, the focus and dose values applied to each of the dies during the fabrication process are slightly different, but it is assumed that across the surface of each individual die the focus and dose are substantially constant. Below the focus is considered as a parameter of interest, which it is desired to evaluate, but this is just an example, and any of the other parameters of interest described above may be used instead.

For each die, of each of the seven samples, 100 measurements were made at 100 respective locations on the surface of the die using SXR light. This corresponds to step 601 of method 100. Each location produced a respective pixelated diffraction image, such as the diffraction image shown in Figure 8(a). Figure 8(b) is an enlarged view of a portion of the diffraction image of Figure 8(a).

In step 602, for each die, a respective PCA analysis (which is an example of a component extraction method which is also a dimensionality reduction method) is done of the respective diffraction images for the 100 respective locations on the die, to derive a plurality of PCA components (e.g. five or six components, but it may be higher or lower). The number of PCA components is much lower (e.g. at least 100 times lower, and more normally at least 10000 times lower) than the number of pixels in each of the diffraction images. Each PCA component can be represented as a normalised vector in the measurement space, and the vectors for different PCA components are orthogonal. A given diffraction image corresponds to a point in a space having a number of dimensions equal to the number of PCA components, where the coordinates of the point are the respective amplitudes of the PCA components in the image.

Each PCA components is associated with a respective value (eigenvalue) which indicates the extent to which it explains the set of diffraction images, i.e. the extent that the corresponding PCA component appears in the set of diffraction images for the respective locations of the die. Typically, one or more of the PCA components encode the similarity between the diffraction images for the die, while one or more other PCA components indicates a respective respect (i.e. a respective vector in the space of the measured signals) in which the diffraction images for the die differ from each other.

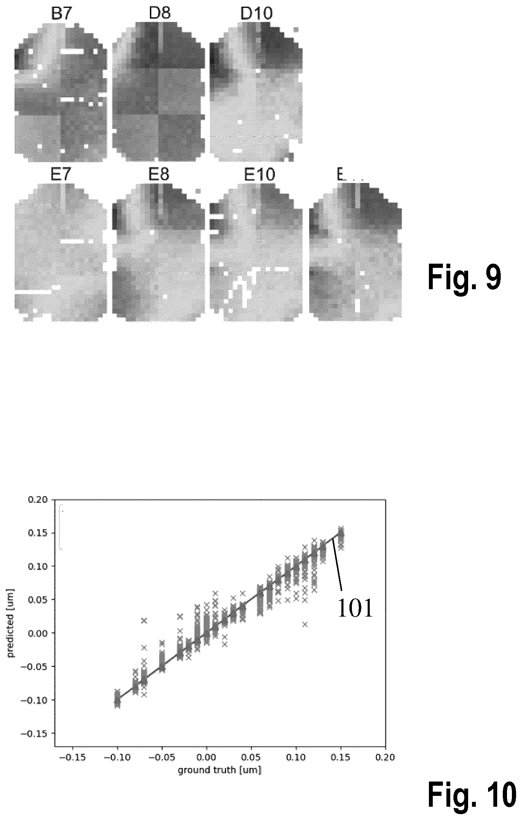

For this implementation example, it is believed that the diffraction images are subject to parasitic variation in the measured data, and this can be confirmed by considering the first PCA component which encodes variance of the diffraction images (i.e. the one which captures the most variance in the 100 diffraction images). The amplitude of this component for each of the 100 locations is illustrated in Figure 9, for each of the dies, of each of the seven samples, where the darkness of the colour for each of the locations indicates the amplitude for that location of the first PCA component for the corresponding die. It will be seen that there are significant variations of the amplitude of this principal component in different locations of each die. However, as noted above, it is believed that each of the locations of a given die the focus (or other parameter of use, such as the dose) was substantially equivalent, so the variation is due to other factors, mainly parasitic noise. This parasitic noise makes it difficult to estimate the respective focus and dose for different ones of the dies (i.e. different products produced by the fabrication process at the same time as a single batch), as well as to compare different batches of products produced by the fabrication process at different times.

This is illustrated in Figure 10, which shows how the respective raw diffraction image for each location captured in step 601 can be used to estimate the focus value for a given location. This is done according to a known process using a using a three-layer neural network having respectively 50, 20 and 10 neurons in the input layer, hidden layer and output layer. The horizontal axis in Figure 10 is the ground truth (actual focus value) for each location value, and the vertical axis shows the focus value estimated by the neural network. The line 101 is plotted to show where the ground truth equals the predicted value, and each of the crosses in Figure 10 shows, for a corresponding item of validation data (i.e. not the training data the neural network was trained on), the estimated focus output by the neural network for a corresponding one of the locations. It will be seen that spread of the crosses from the line 101 is high, indicating the accuracy of estimating the focus for each location is low.

In step 603, a plurality of pixels of the diffraction images which are associated with one or more of the principal components encoding the variance of the diffraction images are identified. Principle components which encode variance may be identified, for example, as components for which the distribution of a value indicating the degree to which the component is present in each of the diffraction images (i.e. a dot product of the normalised vector in the measurement space which represents the component and a vector in the measurement space corresponding to the diffraction image) is centred on zero.

In the example implementation considered here, one or more principal components which encode variance in the images are considered (for example, the five such principal components having the largest respective eigenvalues). For each such component, a corresponding set of measured signals (i.e. pixels of diffraction image of Figure 8(a)) associated with the component are identified. These may be the measured signals for which the corresponding elements of the normalised vector in the measurement space which represents the component, which are above a threshold.

In step 604, for each of the pixels identified in step 603, a corresponding pixel value for the component is defined. The pixel value of the pixel for the component is the amplitude of the corresponding component of the normalised vector, weighted by the eigenvalue for the component.

For each of the pixels, the corresponding pixel value for each of the plurality (e.g. five) components are added. It is then determined whether, for each pixel, the sum of the pixel values is above a threshold. A combined mask is formed which masks any pixel for which the sum of the pixel values is above the threshold.

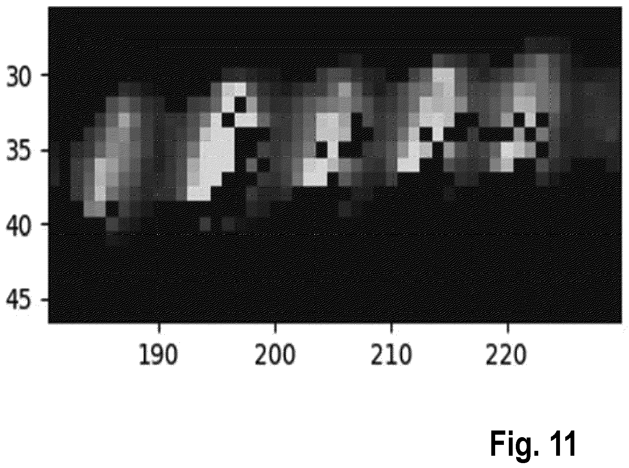

This mask is applied to each of the diffraction images obtained in step 601. Thus, a filtered signal is formed from the diffraction images in which pixels associated with the plurality (e.g. five) components have been removed. Figure 11 indicates how the expanded portion of the diffraction image shown in Figure 8(b) is modified using the combined mask. As will be seen, pixels have been removed from the diffraction image for this location if they are obscured by the combined mask. The set of diffraction images for the 100 locations, in which corresponding pixels have been removed from each diffraction image according to the combined mask, forms a filtered signal.

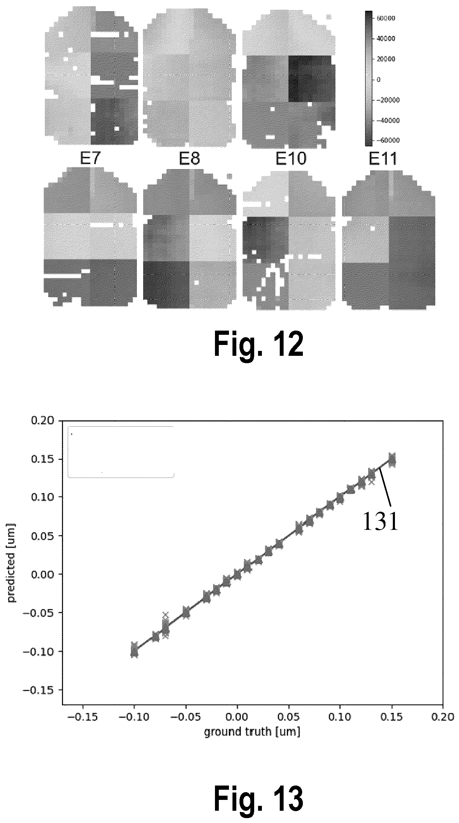

Parasitic noise in the filtered signal is less than in the original diffraction images. This may be seen from Figure 12 which, for each location in each die, plots the amplitude in the filtered signal of the same component obtained in the PCA analysis for the die which was used to obtain Figure 9. Again, the darkness of the colour for each of the locations indicates the amplitude for that location of the first PCA component for the corresponding die. It will be seen that this amplitude is approximately constant over each of the dies, showing that the parasitic noise has been much reduced.

Figure 13 shows the result of using the same neural network which was used to produce Figure 10 to estimate the focus (parameter of interest) for each location using the filtered signal (an example implementation of step 605 of method 600). Again, the horizontal axis in Figure 13 is the ground truth (actual focus value) for each location value, and the vertical axis shows the focus value estimated by the neural network. The line 131 is plotted to show where the ground truth equals the predicted value, and each of the crosses in Figure 13 shows, for an item of validation data, the estimated focus output by the neural network for one of the locations. It will be seen that spread of the crosses from the line 101 is very low, indicating that the accuracy of the neural network in estimating the focus for each location is high. In fact, the 3σ value of the mean error per die is reduced by a factor of at least ten in Figure 13 as compared to Figure 10.

In principle, instead of using method 600, a similar improvement in the quality of inference of the parameter of interest might be attainable by making the neural network more sophisticated (i.e. adding more layers or neurons), but this is not easy and takes much trial-and-error design time. Increasing the size of the neural network has to be balanced with other factors, such as keeping learning times and dropout rate manageable, to prevent overfitting while still resulting in good performance. By using the method 600, the user is relieved from having to undertake this process, because a higher proportion of the variance in the filtered signal than in the original dataset of measured signals represents the parameter of interest.

In variants of the embodiment, the parameter of interest may be obtained using a Fourier analysis of the filtered signal (e.g. a spatial Fourier transform based on the positions of the array of locations on the die) instead of, or in addition to, the use of a neural network. Such a technique is described in WO 2021/121906, which is incorporated herein by reference in its entirety. Using the filtered signal of the embodiment as an input to the auto-correlation method proposed in this reference is expected to produce improved results.

In the explanation above, the dimensional reduction step 602 was performed by a PCA analysis. This has the advantage that fast algorithms are known to implement the analysis, and for each PCA component the associated measured signals are easy to identify, since each PCA component corresponds to a vector in the space of the measured signals.

However, other possibilities may be used for the dimensional reduction step 602. For example, it may be performed by a singular value decomposition (SVD), which is another example of a dimensional reduction method. These have similar advantages.

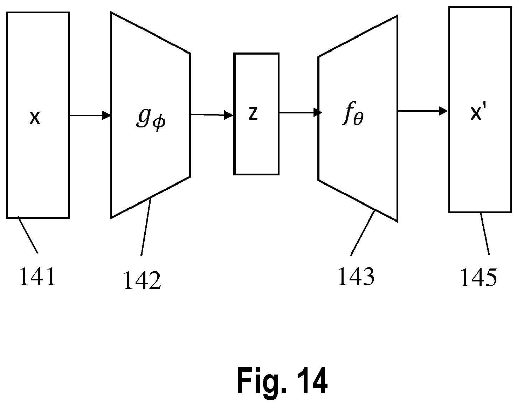

Alternatively, the component extraction step 602 may be performed using the dataset of measured signals (e.g. the respective diffraction image for each of the locations on one die) as the training data for a machine learning model having a "latent space". An example of such a machine learning model (an auto-encoder) is shown in Figure 14. The auto-encoder is a machine learning model which receives an input 141 denoted by the vector x. An encoder unit 142 performs a function *g_{φ}*(*x*) on the vector x to generate a "latent vector" z. The latent vector z has fewer components than the vector x so the encoder unit 142 performs a dimensional reduction. Each component is said to be a "latent variable". The space in which the vector z is defined is referred to as a latent space. The auto-encoder further contains a decoder unit 143 which performs a function *f_{θ}*(*z*) on the latent vector z to generate an output 145 which is a vector denoted x' having the same number of components as the input vector x. Each of the encoder unit 142 and the decoder unit 143 may be implemented by one or more layers of neurons, which perform respective functions *g_{φ}*(*x*) and *f_{θ}*(*z*) defined by respective sets of numerical parameters denoted respectively by *φ* and *θ*.

Initially, the parameters *φ* and *θ* may take any values (e.g. they may be random), but they are trained in a training process (by known training algorithms) iteratively together (e.g. with updates to the parameters *φ* and *θ* happening simultaneously or being interleaved) using examples of the vector x such that the output x' is made as close as possible to x. Since the latent vector z has fewer components than the input vector x, the parameters *φ* evolve such that latent variables encode the most salient features of the input vector x.

In one implementation of step 602, the sets of measured signals in the dataset (e.g. the diffraction images) may be used as a training set of the training process. In the training process, the sets of measured signals are successively applied as the input 142 to the machine learning model, and a modification is made to the parameters *φ* and/or *θ* such that the corresponding output 145 of the auto-encoder is more like this set of measured signals. For example, in the case that the set of measured signals is a diffraction image from one of the locations of the die (e.g. as shown in Fig. 8(a)), the number of dimensions in the input vector x may be equal to the number of pixels of the diffraction image.

The training of the machine learning model - so that upon any one of the sets of measured signals being input to the machine learning model, approximately the same set of measured signals is output as the output 145 - is performed using the measured signals of the dataset as the training set. The encoder unit 142 produced in this process defines a correspondence between the measurement space and the latent space, and the decoder unit 143 provides the inverse function of this correspondence. The latent space is a dimensionally reduced space compared to the measurement space in which the vector x (and vector x') are defined. Each of the latent variables is one of components obtained in step 602. A given latent variable typically encodes a way in which the sets of measured signals used as the training data differ from each other.

In this case, step 603 can be performed by as follows. First, one of the sets of measured signals x (e.g. one of the input vectors used in the training, such as one of the diffraction images) may be input to the encoding unit 142 to obtain a corresponding latent vector z. To obtain a set of measured signals which correspond to the given one of the latent variables, the latent vector z is modified in that latent variable (only) to produce a modified latent vector *z'.* For example, a quantity *8* may be added (or subtracted) to the given one of the latent variables, while leaving the other latent variables of *z* unchanged. The modified latent vector *z'* is input to the decoding unit 143 to produce an output *x'.* The difference between *x* and *x'* (that is, *x-x'*) is now determined, and it is determined whether the magnitude of each element of *x-x'* is above or below a threshold. Those elements of *x-x'* having a magnitude above the threshold are respectively identified as the measured signals which are associated with the given one of the latent variables. This process may be repeated for each of one or more of the latent variables in turn.

In a further possibility, the component extraction step 602 may be performed by a method which does not necessarily perform dimensional reduction. One such method is ICA. Implementations of ICA generally do not reduce the dimensionality of the dataset they operate on. For example, if an *nxn* pixel image is input to the method, the output is multiple images of the same size. Performing step 602 by an ICA method may mean that step 603 of identifying the measured signals is simple because the ICA itself delivers the pixel mask (which is one or more of the independent components) in image space. That is, there is no need to transform from a dimensionally-reduced space into the mathematical space in which the measured signals are orthogonal, because the ICA itself outputs in the latter space.

In a further possibility, step 602 may include perform multiple successive dimensionality reduction sub-steps. For example, it may include performing a PCA to obtain PCA components, then feeding the PCA components into a further dimensionality method, e.g. one based on latent variables, such as the method using the auto-encoder of Figure 14 described above, to reduce the number of components further.

Many other variations are possible of the example implementation of the method 600 explained above within the scope of the invention. For example, in the example implementation a single diffraction image is obtained for each location, but in a variation multi-angle exposures may be used for each location, as is known for SXR imaging. That is, whereas in the example implementation of the method 600 explained above, steps 602-603 are performed after imaging data is obtained for each of the locations on the die. In a variant, the method 600 is performed "on the fly", when only the diffraction images for a few of the locations on the product are available. The filtered signal may then be obtained from the part of the dataset of measured signals for those few locations. In other words, in measuring a single product, the method 600 may be performed repeatedly, each time in respect of a sub-set of the locations on the product. The overhead of performing method 600 in this way is reduced. If the parameter(s) of interest remain stable over a period of time, which is the case for most metrology applications (e.g. to identify OV (overlay), CD, EPE (edge placement error)), the mask can be updated dynamically as data for different locations becomes available. This means that for each measurement process, only the measurements signals for a few locations would be needed, and the mask would not only improve in time but also be able to handle situations in which different locations experienced different conditions (e.g. if the parameter of interest is different for different ones of the locations).

The accuracy of this method is greater if the number of images which is captured for each location is greater than one. Such imaging techniques are known, for example, for background removal and other image correction techniques which require an average or median value.

In a further variant, the images used may be real space images rather than diffraction images. That is, the measured signals may be corresponding pixels of images of the products in real space, and each image is a real space image of a respective portion of the product including the corresponding location. In this case, the removal of certain ones of the measured signals may include removing from the images structures which are repetitive as between the locations on the product. For example, suppose that each measured location includes a contact hole, which may be at a different position in real-space images of different locations (e.g. if the locations are defined based on repeating logic structures in the product, and the pitch of the contact holes is not the same as that of the logic structures). In this case, an additional pattern-recognition step may be performed to identify the contact holes and remove them. The parasitic pixel removal process of steps 602-605 may be performed subsequently on the corrected images with the contact holes already removed.

In further variants, the process may be used to compare products produced by the fabrication process at different times. Steps 601-604 of method 600 are performed for one or more products produced at least two times, to obtain a respective filtered signal for each of the two times. The filtered signals can be compared to determine that there has been a change in a parameter of interest between the times.

Optionally, the components derived by dimensional reduction from measured signals for one of the products at a first time may be used to obtain a parameter of interest of a corresponding product fabricated at a different (e.g. later) time, on the assumption that the factors causing parasitic noise will be similar at the two times. However, when the production process or measurement process changes significantly (e.g. a lens is changed) it is advisable to repeat the method of Figure 6 to derive the dimensionally-reduced components for newly produced products.

Further embodiments are disclosed in the subsequent numbered clauses:
1. A method of estimating a parameter of a fabrication process comprising;
   (a) for each of a plurality of locations on a product of the fabrication process at which the parameter of interest is the same, using a measurement process to derive a plurality of corresponding measured signals, the measured signals for each location comprising respective pixels of at least one respective image generated for the location;
   (b) applying a component extraction method to a dataset including the measured signals to obtain one or more components indicative of variations in the measured signals between the locations;
   (c) identifying one or more of the measured signals which are associated with at least one of the components, the identified measured signals comprising at least one set of corresponding pixels in the respective images for the plurality of locations;
   (d) deriving a filtered signal from the measured signals in which the contribution of the identified one or more measured signals is at least reduced relative to the other measured signals; and
   (e) estimating the parameter of the fabrication process based on the filtered signal.
2. A method according to clause 1 in which, for each location, the at least one image comprises at least one diffraction image for the location, and said step (c) of identifying the one or more measured signals comprises identifying at least one set of corresponding pixels in the respective diffraction images for the plurality of locations.
3. A method according to clause 1 or clause 2 in which the step of identifying the one or more measured signals comprises converting the one or more obtained components from a mathematical space in which the components are orthogonal into a mathematical space in which the measured signals are orthogonal, and identifying the one or more measured signals based on the converted components.
4. A method according to any of clauses 1-3 in which the filtered signal is obtained by applying a mask to each of the images to remove from the images the pixels corresponding to each of the identified measured signals.
5. A method according to any preceding clause, wherein identifying one or more of the measured signals comprises determining for the at least one component, at least one set of corresponding pixels in the respective images for the plurality of locations which make a contribution to the component greater than a threshold value.
6. A method according to any preceding clause, wherein the component extraction method is a dimensional reduction method which produces a number of components smaller than the number of components of the dataset.
7. A method according to clause 6 in which the dimensional reduction method comprises applying a principal component analysis (PCA) or a singular value decomposition (SVD) to the dataset of measured signals to obtain the components.
8. A method according to any of clauses 1 to 5, wherein the dimensional reduction method comprises deriving the components as latent variables generated by a machine learning model trained to generate the latent variables upon receiving a plurality of the measured signals.
9. A method according to clause 8 in which the measured signals associated with at least one of the latent variables are identified by modifying at least one of the latent variables derived from a set of the measured signals, obtaining a plurality of inverted signals from the modified latent variables by inverting the function of the machine learning model, and identifying a subset of the set of measured signals which differ to the greatest extent from the corresponding inverted signals.
10. A method according to any of clauses 1 to 5, wherein the component extraction method is an independent component analysis (ICA) method.
11. A method according to any preceding clause in which the set of steps (a)-(e) is performed repeatedly for successive ones of a set of products formed together in the fabrication process, and in each performance of the method the set of locations are locations on a corresponding one of the products.
12. A method according to any preceding clause further comprising performing the set of steps (a)-(e) to derive a respective filtered signal from respective products of the fabrication process for successive respective additional performances of the fabrication process, each filtered signal being generated from measured signals derived from the corresponding product of the fabrication process, and in each filtered signal the contribution of the identified one or more measured signals being at least reduced relative to the other measured signals,
   the estimation of the parameter comprising comparing the respective filtered signals for different ones of the successive performances of the fabrication process.
13. A method according to any preceding clause wherein the fabrication process is a lithographic process.
14. A method according to any preceding clause wherein the estimating the parameter of the fabrication process based on the filtered signal is performed by a neural network.
15. A method according to any preceding clause wherein the estimating the parameter of the fabrication process based on the filtered signal is performed based on a Fourier analysis of the filtered signal.
16. A computing system for estimating a parameter characterizing a fabrication process, the measurement system comprising a processor arranged to receive for each of a plurality of locations on a product of the fabrication process, a corresponding plurality of measured signals which comprise respective pixels of a respective image generated for the location, and a recording medium storing program instructions operative, upon being performed by the processor, to cause the processor:
   to apply a component extraction method to a dataset including the measured signals to obtain one or more components indicative of variations in the measured signals between the locations;
   to identify one or more of the measured signals which are associated with at least one of the components, the identified measured signals being at least one set of corresponding pixels in the respective images for the plurality of locations;
   to derive a filtered signal from the measured signals in which the contribution of the identified one or more measured signals is at least reduced relative to the other measured signals; and
   to estimate the parameter of the fabrication process based on the filtered signal
17. A lithographic cell comprising:
   a lithographic apparatus;
   an inspection apparatus for obtaining, for each of a plurality of locations on a product of the lithographic fabrication apparatus, at least one measured signal for each location; and a computing system according to clause 16, the processor of the estimation system being configured to receive the measured signals obtained by the inspection apparatus.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to electromagnetic radiations with specific wavelengths, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

## Claims

1. A method of estimating a parameter of a fabrication process comprising;
(a) for each of a plurality of locations on a product of the fabrication process at which the parameter of interest is the same, using a measurement process to derive a plurality of corresponding measured signals, the measured signals for each location comprising respective pixels of at least one respective image generated for the location;
(b) applying a component extraction method to a dataset including the measured signals to obtain one or more components indicative of variations in the measured signals between the locations;
(c) identifying one or more of the measured signals which are associated with at least one of the components, the identified measured signals comprising at least one set of corresponding pixels in the respective images for the plurality of locations;
(d) deriving a filtered signal from the measured signals in which the contribution of the identified one or more measured signals is at least reduced relative to the other measured signals; and
(e) estimating the parameter of the fabrication process based on the filtered signal.

2. A method according to claim 1 in which, for each location, the at least one image comprises at least one diffraction image for the location, and said step (c) of identifying the one or more measured signals comprises identifying at least one set of corresponding pixels in the respective diffraction images for the plurality of locations.

3. A method according to claim 1 or claim 2 in which the step of identifying the one or more measured signals comprises converting the one or more obtained components from a mathematical space in which the components are orthogonal into a mathematical space in which the measured signals are orthogonal, and identifying the one or more measured signals based on the converted components.

4. A method according to any of claims 1-3 in which the filtered signal is obtained by applying a mask to each of the images to remove from the images the pixels corresponding to each of the identified measured signals.

5. A method according to any preceding claim, wherein identifying one or more of the measured signals comprises determining for the at least one component, at least one set of corresponding pixels in the respective images for the plurality of locations which make a contribution to the component greater than a threshold value.

6. A method according to any preceding claim, wherein the component extraction method is a dimensional reduction method which produces a number of components smaller than the number of components of the dataset.

7. A method according to claim 6 in which the dimensional reduction method comprises applying a principal component analysis (PCA) or a singular value decomposition (SVD) to the dataset of measured signals to obtain the components.

8. A method according to any of claims 1 to 5, wherein the dimensional reduction method comprises deriving the components as latent variables generated by a machine learning model trained to generate the latent variables upon receiving a plurality of the measured signals.

9. A method according to any of claims 1 to 5, wherein the component extraction method is an independent component analysis (ICA) method.

10. A method according to any preceding claim in which the set of steps (a)-(e) is performed repeatedly for successive ones of a set of products formed together in the fabrication process, and in each performance of the method the set of locations are locations on a corresponding one of the products.

11. A method according to any preceding claim further comprising performing the set of steps (a)-(e) to derive a respective filtered signal from respective products of the fabrication process for successive respective additional performances of the fabrication process, each filtered signal being generated from measured signals derived from the corresponding product of the fabrication process, and in each filtered signal the contribution of the identified one or more measured signals being at least reduced relative to the other measured signals,
the estimation of the parameter comprising comparing the respective filtered signals for different ones of the successive performances of the fabrication process.

12. A method according to any preceding claim wherein the fabrication process is a lithographic process.

13. A method according to any preceding claim wherein the estimating the parameter of the fabrication process based on the filtered signal is performed by a neural network.

14. A method according to any preceding claim wherein the estimating the parameter of the fabrication process based on the filtered signal is performed based on a Fourier analysis of the filtered signal.

15. A computing system for estimating a parameter characterizing a fabrication process, the measurement system comprising a processor arranged to receive for each of a plurality of locations on a product of the fabrication process, a corresponding plurality of measured signals which comprise respective pixels of a respective image generated for the location, and a recording medium storing program instructions operative, upon being performed by the processor, to cause the processor:
to apply a component extraction method to a dataset including the measured signals to obtain one or more components indicative of variations in the measured signals between the locations;
to identify one or more of the measured signals which are associated with at least one of the components, the identified measured signals being at least one set of corresponding pixels in the respective images for the plurality of locations;
to derive a filtered signal from the measured signals in which the contribution of the identified one or more measured signals is at least reduced relative to the other measured signals; and
to estimate the parameter of the fabrication process based on the filtered signal.
